# EUROPÄISCHE PATENTANMELDUNG

(11) **EP 1 634 655 A2**
(43) Veröffentlichungstag der Anmeldung: **15.03.2006**
(21) Anmeldenummer: 05017938.1
(22) Anmeldetag: 18.08.2005
(51) Int. Cl.: B05D 1/18, B05C 3/18

(54) **Verfahren und Vorrichtung zur Flüssigbeschichtung**

(30) Priorität: 13.09.2004 DE 102004044576
(71) Anmelder: Schott AG, 55122 Mainz (DE)
(72) Erfinder: Ottermann, Clemens, Dr., 65795 Hattersheim (DE); Voges, Frank, Dr., 67133 Maxdorf (DE); Bange, Klaus, Dr., 55270 Jugenheim (DE); Brandes, Kai, 65474 Bischofsheim (DE); Reichel, Peter, 55122 Mainz (DE)
(74) Vertreter: Herden, Andreas F.

(57) **Zusammenfassung**

Um eine materialsparendes und gleichmäßiges Flüssigbeschichten von Substraten zu ermöglichen, sieht die Erfindung ein Verfahren zur Flüssigbeschichtung vor, bei welchem mit einer seitlich geöffneten Rinne (5) und eine der seitlichen Öffnung (47) der Rinne (5) zugewandte Fläche (91) eines Substrats (9) ein Reservoir (6) gebildet wird, welches mit fluidem Beschichtungsmaterial (35) gefüllt wird, wobei ein Spalt (7) zwischen der Rinne (5) und der Fläche (91) des Substrats (9) verbleibt und die Flüssigkeitsoberfläche (36) des fluiden Beschichtungsmaterials (35) an der Fläche (91) des Substrats (9) einen Meniskus (37) ausbildet,
und bei welchem das Substrat (9) an der Rinne (5) oder die Rinne (5) am Substrat (9) entlang einer Richtung (42) mit senkrechter Komponente vorbeigeführt wird.

## Beschreibung

Die Erfindung betrifft allgemein die Herstellung von Beschichtungen durch Flüssigauftrag von Beschichtungsmaterial, insbesondere zur Herstellung organischer elektro-optischer Elemente.

Bei der Herstellung von Schichten organischer lichtemittierender Einrichtungen (OLEDs) ergeben sich besondere Anforderungen an die Schichthomogenität und Schichtdicke. Um die meist sehr dünnen Funktionalschichten von OLEDs aufzubringen, werden dazu die Schichten oft, insbesondere für Display-Anwendungen aufgedampft. Die organischen Substanzen, die dabei verwendet werden können, dürfen dazu aber kein zu hohes Molekulargewicht aufweisen.

Demgegenüber können bei der Flüssigbeschichtung Polymerschichten aufgetragen werden, die eine höhere Stabilität aufweisen. Das Flüssigbeschichten hat auch gegenüber der Vakuumbeschichtung den Vorteil, daß große Flächen einfach und vergleichsweise preisgünstig zu beschichten sind. Die Vakuumbeschichtung von Platten, die einige Quadratmeter groß sind, würde unwirtschaftlich große Vakuumanlagen erfordern. Dementsprechend ist insbesondere für OLEDs im Leuchtmittelbereich, wo im Vergleich zur Display-Fertigung eher große Leuchtflächen zu beschichten sind, die Flüssigbeschichtung günstig.

Zur Flüssigbeschichtung sind eine Reihe von Verfahren, wie beispielsweise Tauchbeschichten, Schleuderbeschichten, Kapillarbeschichten, Schlitzbeschichten, Gieß-, Wasserfall- oder Vorhangbeschichten bekannt. Auch werden verschiedene Druckverfahren, wie Siebdruck oder Tintenstrahldruck zur Flüssigbeschichtung verwendet.

Bei der Flüssigbeschichtung ergibt sich andererseits aber das Problem, homogene, dünne Schichten zu erzeugen. Typischerweise liegen die Schichtdicken der Funktionalschichten einer OLED im Nanometer- oder Mikrometer-Bereich. Es zeigt sich, daß die bei Tauchbeschichtung auftretenden Dickenschwankungen oft unabhängig oder zumindest nicht wesentlich abhängig von der Schichtdicke sind. Dies bedeutet, daß die relativen Dickenschwankungen bei dünnen Filmen stark zunehmen. Durch diesen Effekt wird dann die Homogenität der Leuchtstärke einer OLED-Leuchtfläche, die in dünnen Schichten proportional zur Schichtdicke der elektrolumineszenten Schicht ist, nachteilig beeinflußt. Beim Tauchbeschichten ergibt sich außerdem das Problem, daß große Mengen an fluidem Beschichtungsmaterial im Tauchgefäß vorgehalten werden müssen. Diese großen Mengen verbrauchen sich bei den zumeist erwünschten geringen Schichtdicken nur langsam, wodurch es unter anderem zu Verunreinigungen, Kontaminationsverschleppung und Alterungsprozessen, wie etwa einer allmählichen Aggregation von Polymeren in der Lösung kommen kann. Außerdem ist es in den meisten Fällen wünschenswert, nur eine einseitige Beschichtung auf dem Substrat herzustellen, wohingegen beim normalen Tauchbeschichten naturgemäß die gesamte in die Tauchlösung eingetauchte Oberfläche des Substrats beschichtet wird. Insbesondere die für OLED-Funktionalschichten benötigten Beschichtungsmaterialien sind im allgemeinen außerdem sehr teuer, so daß dies nachteilig für die Produktionskosten ist.

Das Schleuderbeschichten weist den Nachteil auf, daß sich nur relativ kleine Substrate homogen beschichten lassen. Anderenfalls führt das Anwachsen der Radialgeschwindigkeiten mit steigendem Abstand zum Drehpunkt zu unterschiedlichen Turbulenzen der Atmosphäre über der Probenoberfläche und damit zu Änderungen in Trocknungsverhalten des Nassfilms während der Schichtausbildung, was ebenfalls unterschiedliche Schichtdicken verursachen kann. Zudem eignet sich dieses Verfahren nicht für eine wirtschaftliche Großserienproduktion, da beim Schleuderbeschichten ein Großteil des Beschichtungsmaterials -bis zu 95%- vom Substrat wieder heruntergeschleudert wird und in der Regel verlohren geht. Dies gilt besonders für die Herstellung von organischen Polymer-Leuchtdioden, da hier die elektrolumineszierenden Polymere besonders stark durch Verschmutzungen, die im abgeschleuderten Material nur mit großen Aufwand vermeidbar sind, geschädigt werden.

Die Schlitzbeschichtung ist ein weiteres Verfahren zum materialsparenden Flüssigauftrag. Dabei wird das zu beschichtende Substrat entlang einer Schlitzdüse geführt, durch welche gleichzeitig das Beschichtungsmaterial hindurchtritt. Auch dieses Verfahren ist jedoch wenig geeignet, um homogene, sehr dünne Beschichtungen, wie sie zur Herstellung von OLEDs benötigt werden, herzustellen. Bei der Schlitzbeschichtung muß nicht nur die Ziehgeschwindigkeit, sondern zusätzlich auch noch der Fluß des Beschichtungsmaterials und der Abstand zwischen Schlitz und der zu beschichtenden Oberfläche sehr gleichmäßig gehalten werden, was sich in der Praxis als problematisch erweist.

Das Tintenstrahl-Druckverfahren für den Beschichtungsauftrag stellt eine vergleichsweise aufwendige Technologie dar und ist primär zu einer strukturierten Auftragung des Beschichtungsmaterials geeignet. Für die Erzeugung homogener großflächiger Beschichtungen erweist dieses Verfahren sich ebenfalls als problematisch, um gleichmäßige Schichtdicken zu erzielen. Zudem ist das Tintenstrahl-Druckverfahren als lokales Aufbringverfahren im Vergleich zu anderen Verfahren des Flüssigauftrags sehr langsam oder erfordert hohen technologischen Aufwand zur Beschleunigung der Auftragung durch Parallelbetrieb mehrerer Druckköpfe, was zu einer Steigerung der Produktionskosten führt.

Andere Druckverfahren, wie etwa der Siebdruck weisen unter anderem den Nachteil auf, daß die Oberfläche des zu beschichtenden Gutes kontaktiert wird, was bei empfindlichen Oberflächen, wie dies für OLEDs in der Regel typisch ist, zu Ausbeuteverlusten führt. Zudem werden die aufgetragenen Schichten durch den Abrieb der Druckwerkzeuge kontaminiert. Auch kann die große Oberfläche der Druckwerkzeuge schnell zu einem Eintrocknen der Beschichtungslösung und einer Kontamination aufgetragener Schichten mit dem eingetrockneten Material führen.

Gießverfahren, wie etwa die Vorhangbeschichtung schließlich sind aufgrund der großen Mengen von Beschichtungsmaterial, die pro Zeiteinheit aufgetragen werden, für den Auftrag dünner Schichten ungeeignet.

Der Erfindung liegt daher die Aufgabe zugrunde, eine Beschichtungsvorrichtung und ein Verfahren zur Flüssigbeschichtung eines Substrats bereitzustellen, mit welchem dünne Beschichtungen homogen und einseitig unter Einsatz geringer Mengen von Beschichtungsmaterial hergestellt werden können.

Diese Aufgabe wird bereits in höchst überraschend einfacher Weise durch ein Verfahren zur Flüssigbeschichtung eines Substrats und eine Beschichtungsvorrichtung gemäß den unabhängigen Ansprüchen gelöst. Vorteilhafte Ausgestaltungen und Weiterbildungen sind Gegenstand der Unteransprüche.

Demgemäß sieht die Erfindung ein Verfahren zur Flüssigbeschichtung vor, bei welchem mit einer seitlich geöffneten Rinne und einer der seitlichen Öffnung der Rinne zugewandte Fläche eines Substrats ein Reservoir gebildet wird, welches mit fluidem Beschichtungsmaterial gefüllt wird, wobei ein Spalt zwischen der Rinne und der Fläche des Substrats verbleibt und die Flüssigkeitsoberfläche des fluiden Beschichtungsmaterials an der Fläche des Substrats einen Meniskus ausbildet, und
bei welchem Substrat und Rinne entlang einer Richtung mit senkrechter Komponente aneinander vorbeigeführt werden.

Das aneinander Vorbeiführen ist dabei als Relativbewegung zu verstehen, wobei entweder das Substrat oder die Rinne oder beide bewegt werden können.

Im Bereich des Spalts, der eine nach unten geöffnete Öffnung des Reservoirs bildet, findet während des Zieh- und Abscheideprozesses keine Berührung zwischen der zu beschichtenden Fläche des Substrats und der Rinne statt. Dies vermeidet unter anderem, daß die zu beschichtende Fläche durch einen Kontakt mit der Rinne beschädigt, beispielsweise verkratzt wird.

Es kann zusätzlich eine Dichtungseinrichtung vorgesehen sein, um den Spalt nach unten abzudichten. Eine solche Dichtungseinrichtung kann beispielsweise eine Dichtlippe oder eine Dichtrolle umfassen. Sowohl mit einer weichen Dichtlippe, als auch mit einer auf der Substratoberfläche abrollenden Dichtrolle kann eine Beschädigung der Substratoberfläche weitgehend vermieden werden, wenn zwischen der Rinne und der zu beschichtenden Oberfläche des Substrats ein Spalt eingehalten wird.

Besonders vorteilhaft ist es, wenn das Substrat und die Rinne mit einem Spaltabstand aneinander vorbei geführt werden, der so klein ist, daß die Oberflächenspannung des fluiden Beschichtungsmaterials und/oder die Kapillarkräfte des fluiden Beschichtungsmaterials im Spalt ein Auslaufen des Beschichtungsmaterials zwischen der Rinne und der Fläche des Substrats verhindern. Damit wird sowohl eine völlig berührungslose Beschichtung wenigstens im Bereich des Spalts, als auch ein nach unten abgedichtetes Reservoir ermöglicht.

Eine berührungslose Abdichtung des Spalts kann auch durch einen atmosphärischen Druckunterschied zwischen der Flüssigkeitsoberfläche und dem unteren Spaltende unterstützt werden.

Weiterhin können mittels einer geeigneten Einrichtung auch elektrostatische oder auch -im Falle einer entsprechenden magnetostriktiven Flüssigkeit- magnetische Kräfte auf das im Spalt befindliche Beschichtungsmaterial ausgeübt werden, um ein Auslaufen der Rinne zu vermeiden.

Als geeignet haben sich insbesondere Spaltabstände im Bereich von 5µm bis 500µm, bevorzugt im Bereich von 20µm bis 100µm erwiesen.

Das Verfahren ist besonders zur Beschichtung flacher Substrate geeignet. Als Substratmaterialien können insbesondere Glas, Kunststoffscheiben oder -folien, Keramikscheiben oder -flächen, Metallbleche oder -folien, sowie Verbundwerkstoffe aus diesen Materialien, wie etwa Glas-Kunststoff-Laminate verwendet werden. Das Substrat kann auch vorbeschichtet sein. Beispielsweise kann das Substrat auf der zu beschichtenden Fläche für die Herstellung von OLEDs bereits eine leitfähige transparente Beschichtung, wie insbesondere eine Indium-Zinn-Oxidschicht aufweisen.

Der Dicke der einsetzbaren Substrate sind im wesentlichen keine Grenzen gesetzt. So kann als Glassubstrat für OLEDs zum Beispiel Flachglas mit einer Dicke im Bereich von 0,4 mm bis 10 mm, oder sogar Dünnstglas mit Dicken typischerweise im Bereich von 0,03 mm bis 0,4 mm verwendet werden.

Eine entsprechende Vorrichtung zur Flüssigbeschichtung eines Substrats, welche insbesondere zur Durchführung eines Verfahrens gemäß einem der vorstehenden Ansprüche geeignet ist, weist dementsprechend
- zumindest eine seitlich geöffnete Rinne zur Aufnahme von fluidem Beschichtungsmaterial,
- eine Halterung für ein der seitlichen Öffnung der Rinne zugewandtes Substrat, sowie
- eine Einrichtung zum aneinander Vorbeiführen eines gehalterten Substrats und der Rinne entlang einer Richtung mit senkrechter Komponente unter Beibehaltung eines Spalts zwischen Rinne und der der Rinne zugewandten Fläche des Substrats auf.

Das aneinander Vorbeiführen erfolgt vorteilhafterweise so, daß sich die Fläche des Substrats relativ gegenüber dem fluiden Beschichtungsmaterial entlang einer Richtung vom Flüssigkeitsvolumen zu dessen Oberfläche hin bewegt. Damit wird beim Vorbeiführen von Substrats und Rinne die zu beschichtende Fläche des Substrats wie beim Tauchbeschichten relativ gegenüber der Flüssigkeitsoberfläche nach oben bewegt und eine Schicht von fluidem Beschichtungsmaterial oberhalb des Meniskus auf der zu beschichtenden Fläche des Substrats abgeschieden.

Gemäß noch einer bevorzugten Ausführungsform der Erfindung wird beim aneinander Vorbeiführen das Substrat an der Rinne vorbeibewegt. Dazu umfaßt die Einrichtung zum aneinander Vorbeiführen von Substrat und Rinne dementsprechend eine Einrichtung zur Bewegung des Substrats entlang einer Richtung mit senkrechter Komponente.

Unter anderem bei sehr großflächigen Substraten kann es jedoch einfacher sein, wenn anstelle dessen die Rinne am Substrat vorbeibewegt wird. Damit wird eine aufwendige Konstruktion für eine bewegbare Halterung für solche großen Substrate vermieden. Bei einer zur Durchführung dieser Ausführungsform des erfindungsgemäßen Verfahrens entsprechend ausgebildete Vorrichtung umfaßt dazu die Einrichtung zum aneinander Vorbeiführen von Substrat und Rinne eine Einrichtung zur Bewegung der Rinne entlang einer Richtung mit senkrechter Komponente.

Gemäß einer vorteilhaften Weiterbildung der Erfindung ist weiterhin eine Einrichtung zur Zuführung von fluidem Beschichtungsmaterial zur Rinne vorgesehen. Durch das Zuführen von Beschichtungsmaterial während des Beschichtungsprozesses kann so ein Leerlaufen der Rinne vermieden werden. Hierzu kann die Befüllvorrichtung vorteilhaft so ausgelegt sein, dass durch den Füllvorgang keine Schichtdickenänderungen hervorgerufen werden. Die Einrichtung kann auch dazu verwendet werden, eine leere Rinne am Beginn des Beschichtungsprozesses zu befüllen.

Bevorzugt ist die Rinne Bestandteil eines Beschichtungskopfes oder ist in einen Beschichtungskopf eingearbeitet. Vorteilhaft kann bei einer solchen Ausführungsform die seitliche Öffnung der Rinne eine Öffnung in einer Dichtfläche des Beschichtungskopfes bilden. Dabei ist die Dichtfläche einem zu beschichtenden Substrat zugewandt und es wird bei der Beschichtung ein Spalt zwischen Dichtfläche und Substrat beibehalten.

Es ist auch von Vorteil, wenn der Meniskus an der Flüssigkeitsoberfläche im wesentlichen nicht von den Rändern der Rinne beeinflußt wird, so daß die Form des Meniskus allein von den Oberflächenspannungen der beteiligten Materialien bestimmt wird. Daher wird die Rinne gemäß einer bevorzugten Ausführungsform der Erfindung breiter ausgelegt als ein sich an einer zu beschichtender Substratfläche und einer unbegrenzten Flüssigkeitsoberfläche ausbildender Meniskus. Bei einer schmalen Rinne kann demgegenüber die Ausbildung des Meniskus durch die Rinnenform beeinflußt werden. Bevorzugt wird die Breite der Rinne zumindest doppelt so breit wie ein solcher Meniskus ausgelegt. Bei einer hinreichend tiefen Rinne wird auch die Ausbildung des Meniskus nicht wesentlich vom Abstand zwischen Rinne und Substrat, beziehungsweise durch den Spaltabstand beeinflußt.

Unter diesen Voraussetzungen kann die gewünschte Schichtdicke der fertigen, insbesondere verfestigten Schicht durch die Vorgabe von Ziehgeschwindigkeit, Viskosität des fluiden Beschichtungsmaterials, dessen Füllfaktor (d.h. der Feststoffgehalt der Flüssigkeit), dem Winkel der Bewegungsrichtung zur Senkrechten und der Eigenschaften der Atmosphäre oberhalb der Rinne eingestellt werden.

Eine weitere Ausführungsform der Erfindung sieht vor, daß das Vorbeiführen in im Wesentlichen vertikaler Richtung erfolgt. Dazu wird das Substrat so gehaltert, daß die zu beschichtende Fläche des Substrats im Wesentlichen senkrecht, also mit waagerechtem Normalenvektor steht.

Gemäß noch einer Ausführungsform der Erfindung erfolgt das Vorbeiführen nicht in senkrechter, sondern in schräger Richtung, wobei das Substrat dementsprechend so gehaltert wird, daß die zu beschichtende Fläche schräg steht. Mit dieser Ausführungsform werden bei gleicher Ziehgeschwindigkeit gegenüber einer vertikalen Zugrichtung größere Schichtdicken bei stumpfem Winkel zwischen Flüssigkeitsoberfläche und zu beschichtender Fläche des Substrats erzielt. Bei spitzem Winkel können im Vergleich dünnere Schichten hergestellt werden.

Besonders bevorzugt wird das erfindungsgemäße Verfahren für die Herstellung von OLEDs verwendet. Das Verfahren eignet sich diesbezüglich beispielsweise, um die elektrolumineszente Schicht einer OLED aus der Flüssigphase abzuscheiden. Dazu wird das Substrat mittels der erfindungsgemäßen Rinnenbeschichtung mit einem fluiden Beschichtungsmaterial versehen, welches zumindest einen Bestandteil eines elektrolumineszenten Materials aufweist. Bevorzugt kommen hier polymere Materialien oder Bestandteile solcher Polymermaterialien zum Einsatz. Selbstverständlich lassen sich aber auch sogenannte "small molecules" -aufdampfbare organische Substanzen mit im Vergleich zu Polymeren geringen Molmassen-, die sonst üblicherweise über teure Vakuumbeschichtungsprozesse aufgebracht werden, erfindungsgemäß abscheiden.

Auch weitere funktionelle OLED-Schichten lassen sich mit dem erfindungsgemäßen Rinnenbeschichtungsverfahren abscheiden. Beispielsweise kann das Substrat mit einem fluiden Beschichtungsmaterial versehen werden, welches zumindest einen Bestandteil eines Materials einer funktionellen OLED-Schicht, insbesondere einer Lochinjektions-, Lochleiter-, Potentialanpassungs-, Elektronenblockier-, Lochblockier-, Elektronenleiter-, oder Elektroneninjektionsschicht aufweist.

Selbstverständlich ist das Verfahren auch geeignet, andere Beschichtungen aufzubringen. So ist es gemäß einer weiteren Ausführungsform der Erfindung vorgesehen, daß das Substrat mit einem Photolack beschichtet wird. Eine solche Photolack-Schicht auf einem Substrat kann auch für die Herstellung von OLEDs verwendet werden, beispielsweise, um die Photolack-Schicht nachfolgend zu strukturieren und weitere Schichten aufzubringen, welche dann in dem Fachmann bekannter Weise durch Ablösen der darunterliegenden Photolack-Schicht strukturiert werden. Ebenfalls kann die strukturierte Photolackschicht als Isolationsschicht in der Schichtfolge eines OLED-Bauteils zur gezielten lokalen Beeinflussung der erzeugten Lichtintensität dienen.

Auch Funktionalschichten, wie optische Interferenzschichten, beispielsweise Sol-Gel-Schichten oder organische und anorganische Antireflex-, Antikratz-, Antihaft-, oder Antischmutzschichten können unter Verwendung geeigneter fluider Beschichtungsmaterialien erfindungsgemäß aufgebracht werden.

Zur Halterung des Substrats ist gemäß einer Ausführungsform der Erfindung ein Vakuumhalter vorgesehen. Eine derartige Halterung erlaubt ein einfaches Befestigen und eine gut reproduzierbare horizontale Positionierung des Substrats.

Die Halterung kann auch vorteilhaft eine Adhäsionsfläche umfassen, an welcher das Substrat durch Adhäsionskräfte anhaftet. Diese Art der Halterung ist besonders für dünnflächige Substrate mit geringem Gewicht geeignet. Es ist dem Fachmann ersichtlich, daß auch verschiedene Halterungen miteinander kombiniert werden können. So kann ein Vakuumhalter auch beispielsweise eine Adhäsionsfläche aufweisen. Das Anhaften des Substrats an einem Halter mit Adhäsionsfläche kann beispielsweise durch einen geeigneten Kleber oder auch durch direkte Adhäsion zwischen den beteiligten Materialien der Substrat- und der korrespondierenden Halteroberfläche erreicht werden. Noch eine Möglichkeit besteht darin, das Substrat mittels elektrostatischer Kräfte an der Halterung für die erfindungsgemäße Beschichtung zu befestigen.

Eine weitere Möglichkeit der Halterung ist, das Substrat durch Klammerung mittels einer Klemmeinrichtung zu fassen.

Vorzugsweise wird der Abstand zwischen Rinne und Substrat konstant gehalten. Dies kann manuell oder auch automatisch erfolgen.

Um einen vorgegebenen horizontalen Abstand zwischen Rinne und Substrat einhalten und den Prozeßablauf kontrollieren zu können, ist es vorteilhaft, wenn der Abstand durch eine Einrichtung zur Erfassung des horizontalen Abstands zwischen Rinne und der der Rinne zugewandten Fläche eines gehalterten Substrats gemessen wird.

Die Einrichtung zur Erfassung des horizontalen Abstands kann zumindest einen Sensor vom Typ eines Tastsensors, optischen Sensors, Ultraschallsensors oder Staudrucksensors umfassen.

Um eine besonders gleichmäßige Beschichtung zu erzielen, sowie, um ein Auslaufen des fluiden Beschichtungsmaterials in der Rinne durch den Spalt zwischen Substrat und Rinne zu verhindern, ist es außerdem von Vorteil, wenn der horizontale Abstand zwischen Substrat und Rinne geregelt wird. Insbesondere kann dann der Abstand in Abhängigkeit von einer Abstandsmessung geregelt werden.

Dazu weist gemäß einer vorteilhaften Weiterbildung eine erfindungsgemäße Vorrichtung eine Einrichtung zur Regelung des horizontalen Abstands zwischen Rinne und der der Rinne zugewandten Fläche einesgehalterten Substrats auf.

Dabei kann sowohl die horizontale Position der Rinne, als auch des Substrats mittels entsprechender Einrichtungen geregelt werden. Selbstverständlich können auch Einrichtungen zur Regelung beider Positionen vorgesehen sein.

Außerdem ist es aus den vorgenannten Gründen von Vorteil, wenn entlang der Rinne eine konstante Spaltbreite eingehalten wird. Dazu wird gemäß einer Ausgestaltung der Erfindung der Winkel und/oder die horizontale Parallelität zwischen Rinne und der der Rinne zugewandten Fläche eines gehalterten Substrats mittels einer geeigneten Einrichtung geregelt.

Gemäß einer weiteren Ausführungsform der Erfindung wird ein Gasströmungskissen erzeugt, welches auf eine Fläche des Substrats, insbesondere der zu beschichtenden Fläche des Substrats wirkt. Ein solches dynamisches Gaskissen kann vorteilhaft dazu verwendet werden, in einfacher Weise den Abstand zwischen Substrat und Rinne einzustellen oder zu regeln, wobei der Abstand dann wesentlich durch die Bernoullischen Strömungsgesetze bestimmt wird.

Oft ist es wünschenswert, wenn die Beschichtung in einer kontrollierten Atmosphäre erfolgt. So sind beispielsweise viele Schichtmaterialien für OLED-Anwendungen feuchtigkeitsempfindlich, so daß eine trockene Atmosphäre von Vorteil ist. Besonders vorteilhaft kann auch der Sättigungsgrad der kontrollierten Atmosphäre mit den Lösungsmitteln der Beschichtungslösung definiert eingestellt und geregelt werden. Eine weitere Ausgestaltung der Erfindung sieht daher vor, daß die zu beschichtende Fläche des Substrats an wenigstens einem zum gehalterten Substrat hin geöffneten Gasreservoir vorbeigeführt wird. Besonders zweckmäßig ist es dabei, wenn das Gasreservoir oberhalb der Rinne angeordnet ist, so daß die nach dem Vorbeiführen an der Rinne beschichteten Flächenabschnitte anschließend eine kontrollierte Atmosphäre durchlaufen.

Um kontrollierte Bedingungen der Gasatmosphäre im Gasreservoir herzustellen und aufrechtzuerhalten, kann mit Vorteil außerdem zumindest eine Gasversorgungseinrichtung für das Gasreservoir vorgesehen sein. Als Gasversorgungseinrichtung wird in diesem Sinne eine Einrichtung verstanden, welche einzelne oder mehrere Bestandteile einer Gasatmosphäre zu- und/oder abführen kann, die also geeignet ist, die Zusammensetzung und/oder die Dichte der Gasatmosphäre zu beeinflussen.

Für die Kontrolle des Beschichtungsvorgangs und der Qualität der abgeschiedenen Schicht ist es weiterhin von Vorteil, wenn mittels einer entsprechenden Einrichtung zumindest einer der Parameter
- Schichtdicke der aufgetragenen Beschichtung,
- Temperatur des Substrats,
- Temperatur der Rinne,
- Gaszusammensetzung der Atmosphäre über der Rinne,
- Temperatur des Beschichtungsmaterials, und
- Ziehgeschwindigkeit gemessen wird.

Als Ziehgeschwindigkeit haben sich insbesondere Geschwindigkeiten im Bereich von 0,05 mm/Sekunde bis 50 mm/Sekunde, vorzugsweise im Bereich von 0,1 mm/Sekunde bis 10 mm/Sekunde, besonders bevorzugt im Bereich von 0,1 mm/Sekunde bis 0,6 mm/Sekunde als günstig zur Erzeugung gleichmäßiger Schichten für OLED Anwendungen gezeigt. Als geeignet zum Auftrag der gewünschten dünnen Schichten, insbesondere auch bei den vorgenannten Ziehgeschwindigkeiten hat sich außerdem flüssiges Beschichtungsmaterial mit einer Viskosität zwischen 0.1 und 400 mPa·s, bevorzugt zwischen 0.5 und 100 mPa·s, besonders bevorzugt zwischen 5 und 1.00 mPa·serwiesen.

Um eine besonders gleichmäßige Beschichtung zu erreichen, ist es weiterhin günstig, wenn Schwingungen, insbesondere zwischen Substrat und Rinne, sowie Schwingungen des Gesamtsystems, welche sich auf das in der Rinne befindliche Beschichtungsmaterial übertragen, so weit als möglich vermieden werden. Dazu kann vorteilhaft eine Einrichtung zur Schwingungsdämpfung vorgesehen werden. Die Schwingungsdämpfung kann dabei sowohl passiv, als auch aktiv sein.

Die Erfindung wird nachfolgend anhand bevorzugter Ausführungsformen und unter Bezugnahme auf die beigefügten Zeichnungen näher erläutert. Dabei verweisen gleiche Bezugszeichen auf gleiche oder ähnliche Teile.

Es zeigen:
- Fig. 1: eine schematische Ansicht durch ein Ausführungsbeispiel einer erfindungsgemäßen Vorrichtung zur Flüssigbeschichtung mit gehaltertem Substrat,
- Fig. 2: einen vergrößerten Ausschnitt der Rinne,
- Fig. 3: eine perspektivische Ansicht eines Ausführungsbeispiels eines Beschichtungskopfes einer erfindungsgemäßen Vorrichtung,
- Fig. 4: eine Variante des in Fig. 1 gezeigten Ausführungsbeispiels,
- Fig. 5 und Fig. 6: Teile von Ausführungsbeispielen erfindungsgemäßer Vorrichtungen mit Dichtungseinrichtungen zur Abdichtung des Spalts,
- Fig. 7: eine Ausführungsform der Erfindung mit einem Gasreservoir zur Bereitstellung einer kontrollierten Atmosphäre,
- Fig. 8: Teile einer Ausführungsform der Erfindung mit einer Einrichtung zur Erzeugung eines Gasströmungskissens,
- Fig. 9 und 10: eine Schnittansicht und eine perspektivische Ansicht einer weiteren Ausführungsform eines Beschichtungskopfes,
- Fig. 11 und 12: Ausführungsbeispiele mit schräger Zugrichtung,

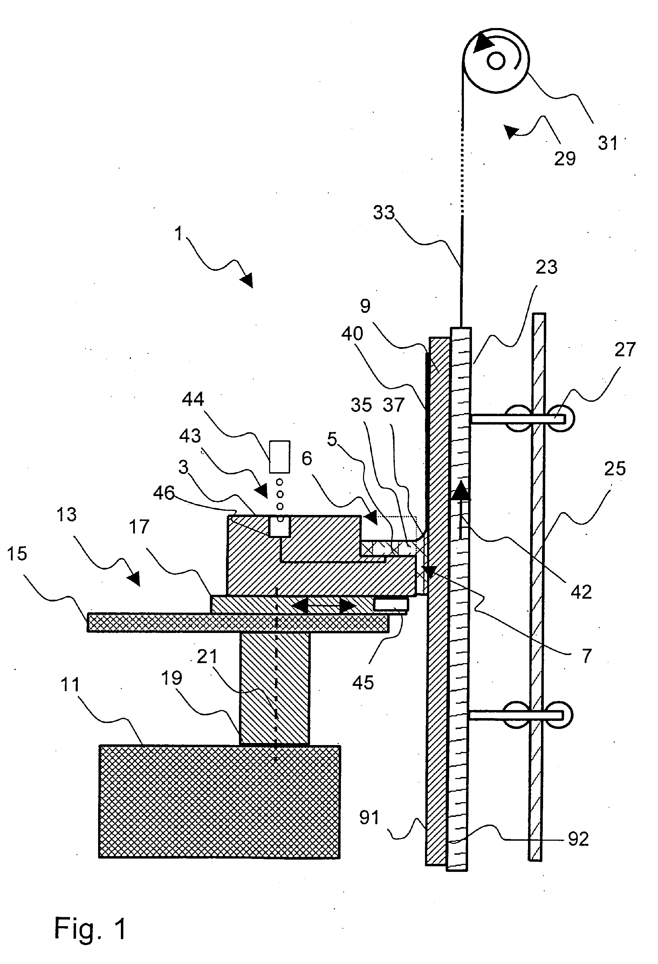

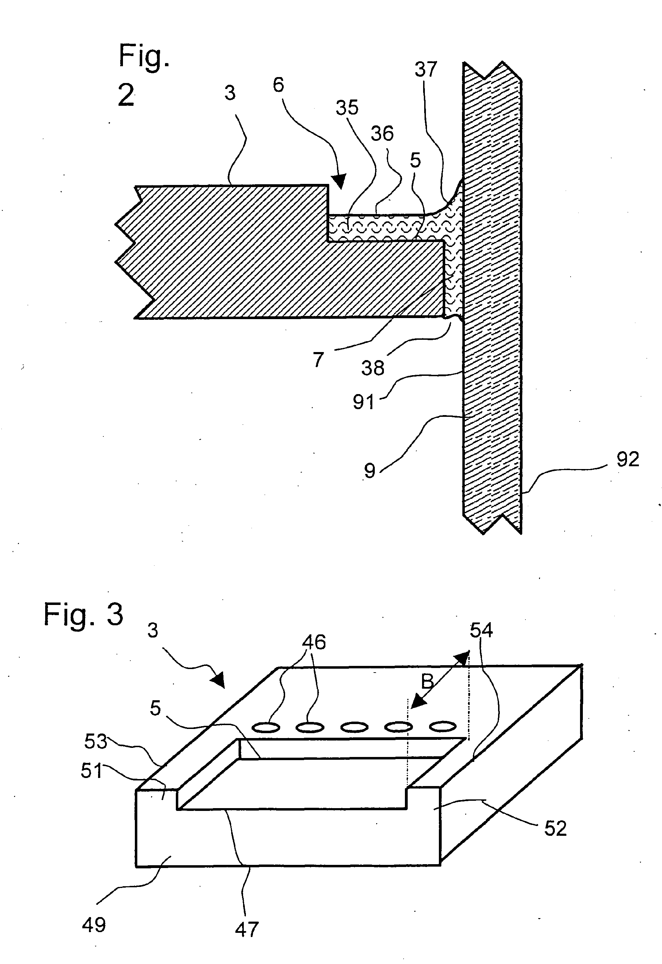

Nachfolgend.wird auf die Fig. 1 und 2 Bezug genommen.
In Fig. 1 ist eine schematische Ansicht eines Ausführungsbeispiels einer als Ganzes mit dem Bezugszeichen 1 bezeichneten Vorrichtung zur Flüssigbeschichtung eines Substrats dargestellt. Die Vorrichtung umfasst einen Beschichtungskopf 3 in Form eines Rinnenblocks, welcher eine Aussparung in Form einer seitlich und oben geöffneten Rinne 5 aufweist.

Fig. 2 zeigt eine gegenüber der Ansicht von Fig. 1 vergrößerte Schnittansicht des Beschichtungskopfs 3 und einem vor dem Beschichtungskopf 3 angeordneten Substrat 9.

Als Material für den Beschichtungskopf 3 ist beispielsweise Edelstahl, insbesondere V4A-Stahl, oder auch Werkzeugstahl geeignet. Auch kann Glas, Glaskeramik, Kunststoff, oder ein Verbundmaterial dieser Werkstoffe als Material für den Beschichtungskopf eingesetzt werden.

Die Vorrichtung umfaßt außerdem eine Halterung 23 für ein der seitlichen Öffnung der Rinne zugewandtes, flaches Substrat 9 mit Seiten 91, 92. Das Substrat kann beispielsweise ein transparentes Glas- oder Kunststoffsubstrat für ein OLED-Leuchtelement sein.

Die Rinne 5 und die der seitlichen Öffnung zugewandte Fläche 91 des Substrats 9 bilden ein nach oben offenes Reservoir 6 zur Aufnahme von fluidem Beschichtungsmaterial 35, welches dort eingebracht wird und sich homogen entlang der Rinne 5 verteilt.

Die Halterung 23 umfasst gemäß einer Ausführungsform der Erfindung einen Vakuumhalter, welcher das Substrat 9 an seiner Fläche 92 haltert. Beispielsweise kann der Halter eine Platte mit porösem Sintermaterial, Gräben und/oder Löchern umfassen, welche auf der dem Substrat abgewandten Seite an eine geeignete Unterdruckquelle angeschlossen ist. Ein Vakuumhalter gestattet ein schnelles und einfaches Wechseln der Substrate. Außerdem wird durch die vollflächige Halterung vermieden, daß das Substrat gegenüber der Halterung schwingen kann.

Gemäß zweier weiterer Ausführungsformen der Erfindung wird das Substrat 9 an der Fläche 92 mittels einer Adhäsionsfläche der Halterung 23 durch Adhäsion oder durch elektrostatische Kräfte gehaltert.

Um eine Beschichtung einer ersten, der Rinne 5 zugewandten Fläche 91 des Substrats durchzuführen, ist außerdem eine Einrichtung zum aneinander Vorbeiführen von gehaltertem Substrats 9 und Rinne 5 entlang einer Richtung 42 mit senkrechter Komponente unter Beibehaltung eines Spalts 7 zwischen Rinne 5 und der der Rinne 5 zugewandten Fläche 91 des Substrats 9 vorgesehen. Diese Einrichtung umfaßt bei dem in Fig. 1 dargestellten Ausführungsbeispiel eine als Ganzes mit 29 bezeichnete Zugeinrichtung mit einer angetriebenen Rolle 31 und einem Seilzug 33, welcher an der Halterung 23 angreift. Dementsprechend wird bei diesem Ausführungsbeispiel der Erfindung das Substrat 9 an der in Rinne vorbeibewegt, die in vertikaler Richtung feststeht.

Zur Führung der Halterung während des an der Rinne 5 Vorbeiführens des Substrats 9 entlang der Zugrichtung 42 sind beispielhaft Führungsrollen 27 vorgesehen, welche mit der Halterung 23 verbunden sind und entlang einer parallel zur -bei dieser Ausführungsform der Erfindung im wesentlichen vertikalen- Zugrichtung 42 verlaufenden Führungsschiene 25 rollen. Selbstverständlich können auch andere, dem Fachmann bekannte Einrichtungen zur Führung der Halterung 23 eingesetzt werden.

Die seitlich geöffnete Rinne 5 bildet, wie anhand von Fig. 1 zu erkennen ist, zusammen mit der der Rinne zugewandten Fläche 91 des Substrats 9 ein Reservoir, welches mit fluidem Beschichtungsmaterial 35 gefüllt werden kann.

Das aneinander Vorbeiführen von Substrat 9 und Rinne 5 wird erfindungsgemäß so durchgeführt, daß der Spalt 7 zwischen der Rinne 5 und der der Rinne 5 zugewandten Fläche 91 des Substrats 9 während des aneinander Vorbeiführens beibehalten wird. Gemäß diesem Ausführungsbeispiel erfolgt das aneinander Vorbeiführen von Rinne und Substrat sogar berührungslos. Dies bedeutet, daß die Fläche 91 keinen Kontakt mit dem Beschichtungskopf 3, beziehungsweise dem Rinnenblock hat.

Die Rinne 5 wird dabei mit fluidem Beschichtungsmaterial 35 gefüllt, wobei aufgrund dessen Oberflächenspannung die Flüssigkeitsoberfläche 36 des Beschichtungsmaterials einen Meniskus 37 an der zu beschichtenden, der Rinne 5 zugewandten Fläche 91 des Substrats 9 ausbildet.

Aufgrund der Kapillarwirkung des Spalts 7 füllt auch dieser sich mit Beschichtungsmaterial 35 und es kommt zur Ausbildung eines weiteren Meniskus 38 am unteren Spaltende.

Das Vorbeiführen erfolgt durch die Bewegung des Substrats 9 entlang der Richtung 42 senkrecht nach oben, so daß sich die Fläche 91 des Substrats relativ gegenüber dem fluiden Beschichtungsmaterial 35 entlang einer Richtung vom Flüssigkeitsvolumen zu dessen Oberfläche hin bewegt. Auf diese Weise wird wie bei einer Tauchbeschichtung oberhalb des Meniskus 37 auf der Fläche 91 ein Film 40 fluiden Beschichtungsmaterials aufgebracht, der dann beispielsweise durch Trocknen und/oder Vernetzen verfestigt werden kann. Um beispielsweise eine Schichtdicke von 80 nm einer verfestigten Beschichtung eines elektrolumineszenten Polymermaterials auf der Fläche 91 zu erzielen, wird die Ziehgeschwindigkeit so eingestellt, daß typischerweise 1 bis 2 Milliliter pro 150 mm² Substratfläche auf dem Substrat anhaften. Dies entspricht ca. 45 bis 90 Milliliter pro Quadratmeter.

Die Schichtdicke des Films 40 wird nach Landau & Levich [L.D. Landau and B.G. Levich, Acta Physicochem.U.R.S.S., 17, 42-54 (1942)] und L.E. Scriven [L.E. Scriven, Mat.Res.Soc.Symp.Proc. Vol. 121, 717-729 (1988)] bestimmt durch das Produkt µ*v, wobei µ die Viskosität und v die Ziehgeschwindigkeit bezeichnen.

Um jeweils einen Film 40 gleicher Dicke aufzutragen, kann dann bei verschiedenen Viskositäten die Ziehgeschwindigkeiten so eingestellt werden, daß das Produkt µ*v konstant ist.

Gleiche Filmdicken werden gemäß der obigen Beziehung dementsprechend jeweils bei folgenden Werten erhalten:
0.05 mm/s Ziehgeschwindigkeit bei 120 mPa·s,
0.1 mm/s Ziehgeschwindigkeit bei 60 mPa·s,
0.6 mm/s Ziehgeschwindigkeit bei 10 mPa·s,
50 mm/s Ziehgeschwindigkeit bei 0.1 mPa·s.

Wird beispielsweise eine Lösung des elektrolumineszenten "SuperYellow" Farbstoffs, erhältlich von Covion Organic Semiconductors GmbH, D-65926 Frankfurt am Main, in Toluol mit Konzentrationen von 5 - 10 g / Liter verwendet, so ergeben sich folgende Viskositäten: 10-12 mPa·s bei 5.0 g/Liter, 20-30 mPa·s bei 7.5 g/Liter.

Während des Auftrags der Beschichtung 40 können außerdem einer oder mehrere der Parameter
- Schichtdicke der aufgetragenen Beschichtung 40,
- Temperatur des Substrats 9,
- Temperatur der Rinne 5,
- Gaszusammensetzung der Atmosphäre über der Rinne 5,
- Temperatur des Beschichtungsmaterials 35, und
- Ziehgeschwindigkeit gemessen und/oder unter Verwendung dieser und eventuell weiterer Parameter geregelt werden. Beispielsweise kann die Schichtdicke der aufgetragenen Beschichtung 40 gemessen und durch eine Anpassung der Ziehgeschwindigkeit geregelt werden.

Um ein Auslaufen des fluiden Beschichtungsmaterials 35 durch den Spalt 7 zwischen Rinne 5 und der Fläche 91 zu verhindern, ist es vorteilhaft, wenn Substrat 9 und Rinne 5 mit einem Spaltabstand des Spaltes 7 aneinander vorbeigeführt werden, der so klein ist, daß die Oberflächenspannung des fluiden Beschichtungsmaterials 35, und/oder die Kapillarkräfte des fluiden Beschichtungsmaterials im Spalt 7 ein Auslaufen des Beschichtungsmaterials 35 durch den Spalt 7 zwischen der Rinne 9 und der Fläche 91 des Substrats 9 verhindert. Für viele fluide Beschichtungsmaterialien haben sich dabei Spaltabstände im Bereich von 5µm bis 500µm, insbesondere im Bereich von 20µm bis 100µm erwiesen.

Außerdem kann gemäß einer Variante der Erfindung ein atmospärischer Druckunterschied zwischen dem unteren Spaltende und der Flüssigkeitsoberfläche 36 des fluiden Beschichtungsmaterials 35 im Reservoir 6 aufgebaut werden, wobei auf der Flüssigkeitsoberfläche 36 ein niedrigerer Druck herrscht. Dadurch wirkt die Druckdifferenz der Gewichtskraft des fluiden Beschichtungsmaterials im Spalt 7 zumindest teilweise entgegen, um ein Auslaufen durch den Spalt 7 zu verhindern.

Um einen hinreichend kleinen Spaltabstand einzuhalten, ist außerdem eine Einrichtung vorgesehen, mit welcher der horizontale Abstand zwischen Substrat 9 und Rinne 5 eingestellt werden kann. Insbesondere ist vorgesehen, den Abstand nicht nur einzustellen, sonder auch unter Verwendung geeigneter Meßwerte zu regeln. Eine Grundeinstellung kann mittels geeigneter Justageeinrichtungen manuell oder automatisch vorgenommen werden.

Bei der in Fig. 1 gezeigten Ausführungsform umfaßt dabei zur Einhaltung des Spaltabstandes die Einrichtung zur Regelung des horizontalen Abstands zwischen Rinne 5 und Substrat 9 eine Einrichtung zur Regelung der horizontalen Position der Rinne 5. Dazu ist die Rinne 5 mit der feststehenden Basis 11 der Vorrichtung 1 über eine Einrichtung 13 zur horizontalen Verschiebung des Beschichtungskopfs mit dem Beschichtungskopf 3, beziehungsweise der Rinne 5 des Beschichtungskopfs 3 beweglich verbunden. Die Einrichtung 13 weist ein Lager 15, sowie einen mit dem Beschichtungskopf 3 verbundenen Schlitten 17 auf. Durch eine Bewegung des Schlittens 17 auf dem Lager 15 wird dementsprechend eine horizontale Positionsänderung des Beschichtungskopfs 3, beziehungsweise der Rinne 5 erreicht.

Der horizontale Abstand zwischen Rinne 5 und Substrat 9 wird gemäß der in Fig. 1 gezeigten Ausführungsform in Abhängigkeit von einer Abstandsmessung durchgeführt. Dazu ist eine Einrichtung 45 zur Erfassung des horizontalen Abstands zwischen Rinne 5 und der der Rinne 5 zugewandten Fläche 91 des Substrats 9 vorgesehen. Die Einrichtung 13 zur horizontalen Verschiebung des Beschichtungskopfs 3 und die Einrichtung 45 zur Erfassung des horizontalen Abstands bilden demgemäß Bestandteile der Einrichtung zur Regelung der horizontalen Position der Rinne 5, wobei die Einrichtung 45 Abstandsmeßwerte liefert, die als Parameter zur Positierung des Beschichtungskopfs 3 und einer Beibehaltung eines konstanten Abstands zwischen Rinne 5 und Fläche 91 verwendet werden. Zusätzlich oder alternativ zu einer automatischen Regelung des Abstands zwischen Rinne 5 und Substrat 9 kann auch eine Einrichtung für eine manuelle Abstandseinstellung vorgesehen sein.

Die Einrichtung 45 zur Erfassung des horizontalen Abstands kann beispielsweise zumindest einen Sensor vom Typ eines Tastsensors, optischen Sensors, Ultraschallsensors oder Staudrucksensors umfassen. Als optische Sensoren können beispielsweise Triangulations- oder Autofokussensoren verwendet werden. Tastsensoren werden bevorzugt an den Enden der Rinne 5 so angebracht, daß die Abtastlinie des oder der Sensoren nicht mit dem von der Rinne 5 überstrichenen Flächenbereich der Fläche 91 überlappt, um eine Beschädigung oder Kontamination des Substrats 9 oder dessen Beschichtung im beschichteten Flächenbereich zu vermeiden.

Damit der Abstand zwischen Rinne 5 und Fläche 91 nicht entlang des Spaltes 7 variiert, müssen Rinne 5 und Fläche 91 möglichst parallel eingestellt werden. Um dies zu erreichen, ist außerdem eine Dreheinrichtung 19 zwischen der feststehenden Basis 11 und dem Beschichtungskopf 3 vorgesehen. Mittel der Dreheinrichtung 19 kann der Beschichtungskopf 3 um die Drehachse 21 rotiert werden. Insbesondere ist auch eine Einrichtung zur Regelung des Winkels zwischen Rinne 5 und der der Rinne 5 zugewandten Fläche 91 eines gehalterten Substrats 9 vorgesehen, um eine möglichst exakte Winkeleinstellung über den gesamten Beschichtungsprozeß hinweg zu gewährleisten. Diese umfaßt beispielsweise zwei Abstands-Messeinrichtungen 45, die entlang einer Richtung parallel zur Rinne 5 angeordnet sind. Aus der Differenz der Abstandsmesswerte kann dann der momentane Winkel der Rinne 5 zur Fläche 91 errechnet und der Winkel oder die horizontale Parallelität von Rinne und Fläche 91 durch entsprechende manuelle oder automatisierte Einstellung der Dreheinrichtung 19 geregelt werden.

Um die Rinne mit dem Beschichtungsmaterial 35 zu befüllen und ein Absenken des Flüssigkeitspegels in der Rinne 5 auszugleichen, ist bei der in Fig. 1 gezeigten Ausführungsform einer erfindungsgemäßen Vorrichtung 1 außerdem eine Einrichtung 43 zur Zuführung von fluidem Beschichtungsmaterial vorgesehen. Die Einrichtung umfaßt beispielhaft eine Tropf- oder Sprüheinrichtung 44, eine Vielzahl von entlang der Rinne angeordneten Näpfen oder Auffangbecher 46, sowie Kapillaren 48, welche die Näpfe 46 mit der Rinne 5 verbinden. Das von der Einrichtung 44 in die Näpfe 46 tropfende oder gesprühte Beschichtungsmaterial gelangt dann durch die Kapillaren 48 in die Rinne 5. Aufgrund der Seitenansicht von Fig. 1 ist nur jeweils ein Napf 46 und eine Kapillare 48 zu sehen. Als Tropf- oder Sprüheinrichtung 44 ist beispielsweise ein Tintenstrahl-Druckkopf geeignet, mit welchem fluides Beschichtungsmaterial hochgenau dosiert werden kann.

Andere Möglichkeiten zur Zuführung des Beschichtungsmaterials sind unter anderem eine geschlossene Schlauchzuführung, oder ein Gießsystem, wie etwa in Form einer Dispenser-Anordnung.

Anstelle solcher Einrichtungen zur Zuführung und Verteilung des fluiden Beschichtungsmaterials kann jedoch das Beschichtungsmaterial auch beispielsweise manuell eingefüllt werden, wobei zweckmäßig eine Menge eingefüllt wird, die hinreichend für einen gesamten Beschichtungsprozess eines Substrats 9 ist.

Die Vorrichtung 1 kann vorteilhaft eine in Fig. 1 nicht dargestellte Einrichtung zur Schwingungsdämpfung umfassen, um Schwingungen zwischen Substrat 9 und Rinne 5 zu vermeiden. Beispielsweise kann die Vorrichtung 1 auf Dämpfungsfüßen ruhen, welche die Übertragung von Bodenschwingungen auf die Vorichtung 1 reduzieren. Auch die schwingungsempfindlichen Komponenten, wie Halterung oder Beschichtungskopf können über Dämpfungselemente montiert sein. Um Schwingungen zu vermeiden, ist es auch besonders vorteilhaft, wenn die Vorrichtung 1 eine hinreichend große Masse aufweist. Hilfreich ist dabei auch eine gute Verwindungssteifigkeit der Vorrichtung und/oder deren Komponenten.

Vorteilhaft ist es auch, wenn das aneinander Vorbeiführen, beziehungsweise die Relativbewegung zwischen Substrat 9 und dem Beschichtungskopf mit der Rinne 5 mit einem vorgegebenen Geschwindigkeitsprofil durchgeführt wird. Das Anfahren am Begin des Beschichtungsprozesses kann insbesondere mit einer ansteigenden Geschwindigkeitsrampe durchgeführt werden, um das Entstehen von Schwingungen durch eine ruckartige Geschwindigkeitsänderung beim Anfahren zu vermeiden. Ebenso kann die Ziehgeschwindigkeit aus gleichen Gründen am Ende des Beschichtungsprozesses langsam und stetig verringert werden.

Auch ist es zur Vermeidung von Schwingungen günstig, wenn die Vorrichtung 1 äußerlich gegen Raum- und Körperschall abgeschirmt wird, beispielsweise durch Abschirmung mit Schallschutzwänden, welche die Vorrichtung 1 umgeben.

Gemäß einer Variante der in Fig. 1 und 2 gezeigten Ausführungsform kann eine erfindungsgemäße Vorrichtung 1 auch mehrere übereinander angeordnete Rinnen 5 aufweisen, mit welchen der Auftrag einer mehrschichtigen Beschichtung möglich ist.

Fig. 3 zeigt eine perspektivische Ansicht eines Ausführungsbeispiels eines Beschichtungskopfs 3. In den Beschichtungskopf 3 ist die Rinne 5 so eingearbeitet, daß die seitliche Öffnung 47 der Rinne 5 eine Öffnung in einer Fläche 49 des Beschichtungskopfs 3 bildet. Die Öffnung 47 ist insbesondere auch nach oben offen, und bildet so einen Einschnitt in der Fläche 49. Die Fläche 49 mit der Öffnung 47 ist bei der Beschichtung eines Substrats der zu beschichtenden Fläche des Substrats zugewandt und dient als Dichtfläche, wobei sich die zu beschichtende Fläche des Substrats und die Fläche 49 des Beschichtungskopfes 3 nicht berühren und ein Spalt zwischen diesen Flächen verbleibt. Eine Abdichtung der Rinne 5 zu deren Enden hin wird durch zwei Abschlußflächen 51, 52, die Bestandteil der Fläche 49 sind und Stirnflächen der die Rinne 5 an ihren Enden begrenzenden Vorsprünge 53 und 54, erzielt. Auch dieser Beschichtungskopf 3 weist Bestandteile eines Systems zur Zuführung und Verteilung von fluidem Beschichtungsmaterial in Form von Näpfen 46, sowie von nicht dargestellten Kapillaren auf, welche die Näpfe 46 mit der Rinne 5 verbinden.

Um den Spalt zwischen der Rinne 5 und dem Substrat 9 möglichst gering halten zu können, ist gemäß einer Ausführungsform der Erfindung die Dichtfläche außerdem planarisiert und poliert. Die Dichtwirkung kann auch beispielsweise verbessert werden, indem die Fläche 49 mit einer flüssigkeitsabweisenden Beschichtung versehen ist. So kann die Fläche 49 etwa eine Teflon-Beschichtung für das Beschichten mit wässrigen Lösungen aufweisen.

Der an der zu beschichtenden Fläche eines gehalterten Substrats anliegende Meniskus an der Flüssigkeitsoberfläche des fluiden Beschichtungsmaterials in der Rinne 5 sollte sich möglichst ungestört ausbilden und nicht von den Rändern der Rinne beeinflußt werden, um eine Abhängigkeit der Schichtdicke einer erfindungsgemäß aufgebrachten Schicht von der Geometrie der Rinne zu vermeiden. Daher wird die Breite B der Rinne 5 gemäß einer bevorzugten Ausführungsform der Erfindung breiter ausgelegt als ein sich an einer zu beschichtender Substratfläche und einer unbegrenzten Flüssigkeitsoberfläche ausbildender Meniskus. Bevorzugt ist die Breite B der Rinne 5 zumindest doppelt so breit, wie ein sich ungestört ausbildender Meniskus.

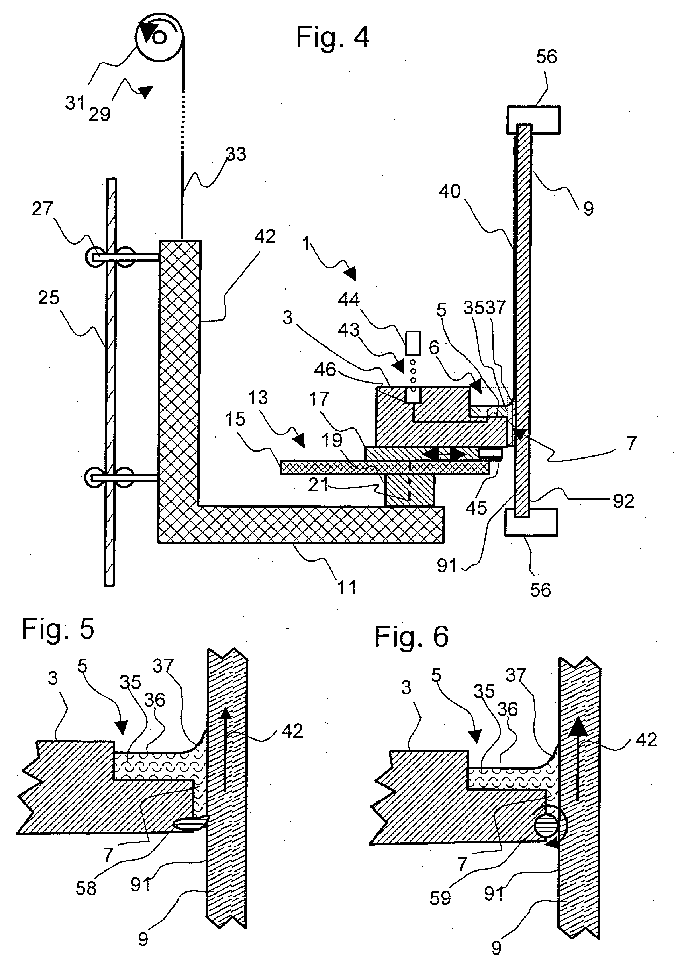

Fig. 4 zeigt eine Variante des in Fig. 1 dargestellten Ausführungsbeispiels der Erfindung. Bei dieser Variante wird das Substrat 9 durch Klammerung mittels einer Klemmeinrichtung 56 gehaltert. Bei diesem Ausführungsbeispiel wird außerdem das Substrat 9 festgehalten und die Rinne am Substrat vorbeibewegt. Dazu ist ähnlich wie bei dem Ausführungsbeispiel der Fig. 1 eine Zugeinrichtung 29 vorgesehen, die aber hier an der vertikal verschieblich mit Führungsrollen 27 an einer Führungsschiene 25 geführten Basis 11 befestigt ist. Dementsprechend wird für die Beschichtung hier eine nach unten gerichtete Zugrichtung 42 gewählt, damit sich die Fläche 91 des Substrats 9 relativ gegenüber dem fluiden Beschichtungsmaterial 35 entlang einer Richtung vom Flüssigkeitsvolumen zu dessen Oberfläche hin bewegt.

Die Fig. 5 und 6 zeigen Teile von Ausführungsbeispielen mit Dichtungseinrichtungen zur Abdichtung des Spalts, wobei ein mit Fig. 2 vergleichbarer Abbildungsausschnitt dargestellt ist. Bei dem in Fig. 5 gezeigten Ausführungsbeispiel umfaßt die Dichtungseinrichtung eine Dichtlippe 58. Das in Fig. 6 abgebildete Ausführungsbeispiel umfaßt eine Dichtungsrolle 59 als Bestandteil einer Dichtungseinrichtung. Bei diesen Ausführungsbeispielen findet zwar kein berührungsloses Vorbeiführen statt, jedoch kommt die zu beschichtende Fläche 91 des Substrats 9 nur mit der weichen Dichtlippe 58, beziehungsweise der auf der Fläche 91 abrollenden Dichtrolle 59 in Berührung, so daß auch hier ein Kontakt mit dem Beschichtungskopf 3 vermieden wird.

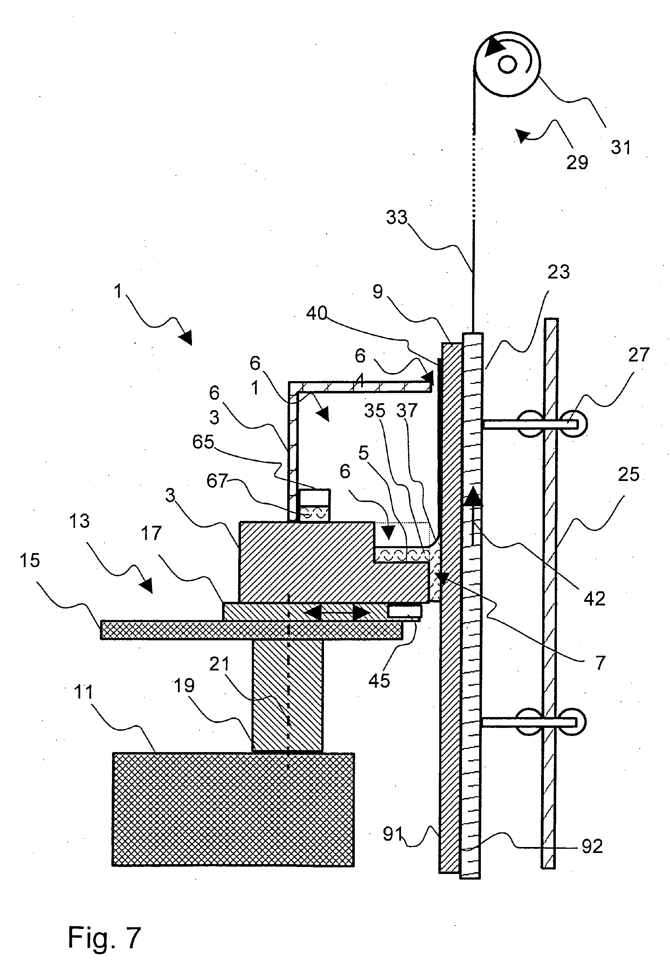

Fig. 7 zeigt eine weitere Ausführungsform einer erfindungsgemäßen Vorrichtung 1. Diese Vorrichtung 1 umfaßt einen Behälter 63, welcher zum gehalterten Substrat 9 hin geöffnet ist und damit ein zur Fläche 91 des Substrats 9 hin geöffnetes Gasreservoir 61 umschließt. Der Behälter 64 ist so ausgebildet, daß beim aneinander Vorbeibewegen von Substrat 9 und Rinne 5 lediglich ein schmaler Spalt 64 zwischen Behälter 63 und der zu beschichtenden Fläche 91 des Substrats 9 verbleibt und eine Berührung der aufgebrachten Beschichtung 40 und dem Behälter 40 vermieden wird. Das Gasreservoir 61 ist dementsprechend bis auf den Spalt 64 von der Umgebung abgedichtet.

Das Gasreservoir 61 kann dann mit einer kontrollierten Atmosphäre versehen werden, um die Bedingungen für die Schichtausbildung oder -verfestigung in gewünschter Weise zu beeinflussen.

Beispielsweise kann im Gasreservoir 61 ein kontrollierter Feuchtigkeitsgehalt für eine Sol-Gel-Beschichtung des Substrats 9 eingestellt werden.

Bei Polymerbeschichtungen kann der im Gasreservoir 61 eingeschlossenen Atmosphäre unter anderem ein Lösungsmittel-Anteil beigefügt werden, um etwa ein zu schnelles und/oder inhomogenes Austrocknen der Beschichtung 40 zu verhindern.

Auch kann beispielsweise eine weitgehend Wasser- und Sauerstoff-freie Atmosphäre im Gasreservoir 61 bereitgestellt werden, wenn feuchtigkeits- und oxidationsempfindliche Materialien erfindungsgemäß aufgebracht werden. Dies ist unter anderem bei vielen für OLEDs verwendeten Materialien der:Fall.

Um die gewünschte Zusammensetzung der Gasatmosphäre zu schaffen, ist außerdem eine Gasversorgungseinrichtung für das Gasreservoir 61 vorgesehen. Bei dem in Fig. 7 gezeigten Ausführungsbeispiel umfaßt die Gasversorgungseinrichtung einen Lösungsmittelverdampfer 65, aus welchem Lösungsmittel in das Gasreservoir 61 hinein verdampft oder verdunstet.

Eine Gasversorgungseinrichtung kann aber auch beispielsweise eine Einrichtung zur Zufuhr und/oder Umwälzung eines wasserfreien Schutzgases für feuchtigkeits- und oxidationsempfindliche Beschichtungen umfassen.

Andererseits können auch gezielt Gase zugeführt werden, welche reaktiv für das Beschichungsmaterial sind, um beispielsweise Vernetzungsreaktionen zu fördern oder zu hemmen .

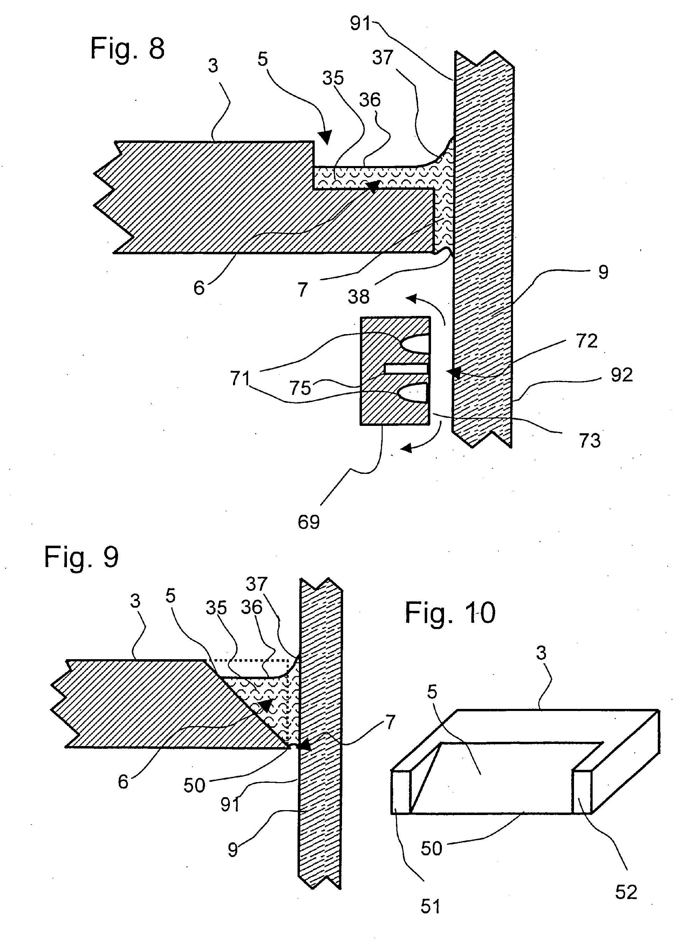

In Fig. 8 sind Teile einer Ausführungsform einer erfindungsgemäßen Vorrichtung mit einer Einrichtung zur Erzeugung eines Gasströmungskissens dargestellt. Die Einrichtung zur Erzeugung eines Gasströmungskissens umfaßt eine Düsenkonsole 69 mit Düsen 71, welche in einer Frontfläche 73 der Düsenkonsole 69 münden. Die Frontfläche 73 ist der Fläche 91 des gehalterten Substrats 9 zugewandt. Die Düsenkonsole 69 ist mit dem Beschichtungskopf 3 verbunden. Durch die Düsen wird Gas in den Zwischenraum zwischen Frontfläche 73 und Fläche 91 geblasen, welches zu den Seiten der Düsenkonsole 69 hin entweicht und so ein dynamisches Gaskissen oder Gasströmungskissen 72 bildet. Durch das Gasströmungskissen 72 wird das Substrat 9 bei geeigneter Halterung und konstantem Gasfluß auf konstantem Abstand zur Frontfläche 73 und damit zum Beschichtungskopf 3 und der Rinne 5 gehalten. Ein Staudrucksensor 75 kann außerdem Meßwerte für eine Abstandsbestimmung liefern, die wiederum als Parameter für eine Abstandsregelung dienen können.

In Fig. 9 ist eine schematische Schnittansicht einer weiteren Ausführungsform eines Beschichtungskopfes mit einem Beschichtungskopf 3 dargestellt. Fig. 10 zeigt eine perspektivische Ansicht dieser Ausführungsform.

Im Unterschied zu den anhand der vorstehend beschriebenen Ausführungsbeispielen weist der Beschichtungskopf 3 hier keine durchgehende Dichtfläche 49 auf. Die Rinne 5 hat hier die Gestalt einer Abfasung der dem Substrat 9 zugewandten Kante, wobei die Abfasung in einer Schneide 50 endet. Auch hier wird die Beschichtung der Fläche 91 so vorgenommen, daß während des aneinander Vorbeiführens ein Spalt zwischen Rinne 5 und Fläche 91 verbleibt, wobei sich dementsprechend der Spalt 7 zwischen der Schneide 50 und der Fläche 91 befindet. Zur seitlichen Abdichtung des Reservoirs 6 an den Enden der Rinne 5 sind, ähnlich wie bei den vorstehend beschriebenen Ausführungsbeispielen Abschlußflächen 51, 52 vorgesehen. Zusätzlich kann durch Vorgabe und Regelung der Füllhöhe der Beschichtungslösung in dem Beschichtungskopf die Breite der Flüssigkeitsoberfläche 36 senkrecht zum Substrat 9 eingestellt werden und damit, über Änderungen in der Ausbildung des Meniskus 37, die Dicke des abgeschiedenen Flüssigkeitsfilms 40 beeinflusst werden.

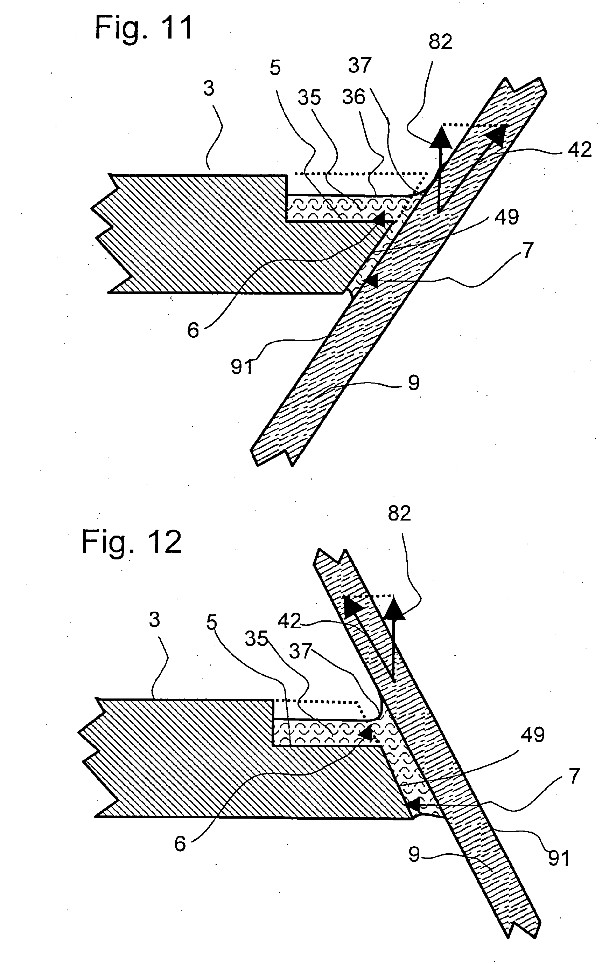

Die Fig. 11 und 12 zeigen Teile von Ausführungsbeispielen, bei welchen Substrat 9 und Rinne 5 entlang einer schrägen Zugrichtung 42 aneinander vorbeigeführt, beziehungsweise relativ zueinander bewegt werden, wobei beispielhaft, ähnlich wie bei der in Fig. 1 gezeigten Vorrichtung 1 das Substrat 9 gegenüber einer feststehenden Rinne bewegt wird. Wie bei den vorstehend beschriebenen Ausführungsformen erfolgt auch hier die Bewegung entlang einer Richtung 42 mit senkrechter Komponente, wobei bei den vorstehend beschriebenen Ausführungsformen durch die vertikale Bewegung die Bewegungsrichtung 42 mit deren senkrechter Komponente zusammenfällt. Bei einer schrägen Zug- oder Bewegungsrichtung 42, wie etwa in den Fig. 11 und 12, ist die senkrechte Komponente 82 von der Bewegungsrichtung verschieden.

Der Beschichtungskopf 3 weist jeweils eine abgeschrägte Frontfläche 49 auf, wobei Substrat 9 und Rinne 5 entlang dieser Fläche 49 aneinander vorbeigeführt werden.

Im einzelnen stehen die Flüssigkeitsoberfläche 36 des fluiden Beschichtungsmaterials und die zu beschichtende Fläche 91 bei der in Fig. 11 gezeigten Ausführungsform in einem stumpfen Winkel zueinander, während die beiden Flächen der in Fig. 12 gezeigten Ausführungsform einen spitzen Winkel einschließen. Ein Meniskus, der sich wie in Fig. 11 zwischen zwei zueinander stumpfwinkligen Flächen erstreckt, führt gegenüber einer vertikalen Zugrichtung bei gleicher Zuggeschwindigkeit zu dickeren Beschichtungen. Entsprechend können bei gleicher Zuggeschwindigkeit mit einer wie in Fig. 12 gezeigten Anordnung im Vergleich zu vertikaler Zugrichtung dünnere Beschichtungen auf der Fläche 91 erreicht werden.

Mit der Erfindung können eine Vielzahl verschiedenartiger beschichteter Substrate hergestellt werden.

Mögliche Anwendungsfelder sind beispielsweise OLEDs für Beleuchtungs- oder Signage-Anwendungen oder für Display-Anwendungen, wie zum Beispiel Backlight-Beleuchtungen für LCD-Anzeigen, etwa von Mobiltelefonen oder PDAs, beziehungsweise Palm-Computer.

Auch können materialsparend und sehr gleichmäßig Photolackbeschichtungen für die Photolithographie, zum Beispiel für Halbleiter oder Display-Anwendungen hergestellt werden.

Außerdem können optische Elemente, wie etwa Interferenzfilter mit der Erfindung hergestellt werden.

Weiterhin ist auch an den Auftrag ein- oder mehrschichtiger Funktionalbeschichtungen gedacht. Beispielsweise eignet sich die Erfindung zur Herstellung von Antireflex-, Antikratz,- Antihaft-, oder Antischmutz-Beschichtungen.

Es ist dem Fachmann ersichtlich, dass die Erfindung nicht auf die vorstehend beschriebenen Ausführungsformen beschränkt ist, sondern vielmehr in vielfältiger Weise variiert werden kann. Insbesondere können auch die Merkmale der einzelnen beispielhaften Ausführungsformen auch miteinander kombiniert werden.

### Bezugszeichenliste:

| | |
|---|---|
| 1 | Vorrichtung zur Flüssigbeschichtung |
| 3 | Beschichtungskopf |
| 5 | Rinne |
| 6 | Reservoir für 35 |
| 7 | Spalt |
| 9 | Substrat |
| 11 | Basis |
| 13 | Einrichtung zur horizontalen Verschiebung von 3 |
| 15 | Lager von 13 |
| 17 | Schlitten von 13 |
| 19 | Dreheinrichtung |
| 21 | Drehachse von19 |
| 23 | Substrathalterung |
| 25 | Führungsschiene |
| 27 | Führungsrollen |
| 29 | Zugeinrichtung |
| 31 | Rolle |
| 33 | Seilzug |
| 35 | Fluides Beschichtungsmaterial |
| 36 | Flüssigkeitsoberfläche |
| 37 | Meniskus an Flüssigkeitsoberfläche |
| 38 | Meniskus an Spaltunterseite |
| 40 | Film fluiden Beschichtungsmaterials auf 91 |
| 42 | Zugrichtung |
| 43 | Einrichtung zur Zuführung von fluidem Beschichtungsmaterial |
| 44 | Tropf- oder Sprüheinrichtung |
| 45 | Abstands-Meßeinrichtung |
| 46 | Napf |
| 47 | Seitliche Öffnung von 5 |
| 48 | Kapillare |
| 49 | Dichtfläche von 3 |
| 50 | Schneide |
| 51,52 | Abschlußflächen |
| 53,54 | Vorsprünge |
| 56 | Klemmeinrichtung |
| 58 | Dichtlippe |
| 59 | Dichtrolle |
| 61 | Gasreservoir |
| 63 | Behälter |
| 65 | Lösungsmittelverdampfer |
| 67 | Lösungsmittel |
| 69 | Düsenkonsole |
| 71 | Düse |
| 72 | Gasströmungskissen |
| 73 | Frontfläche von 69 |
| 75 | Staudrucksensor |
| 82 | senkrechte Komponente von 42 |
| 91 | Erste Fläche von 9 |
| 92 | Zweite Fläche von 9 |
| | |

## Patentansprüche

1. Verfahren zur Flüssigbeschichtung, bei welchem mit einer seitlich geöffneten Rinne (5) und eine der seitlichen Öffnung (47) der Rinne (5) zugewandte Fläche (91) eines Substrats (9) ein Reservoir (6) gebildet wird, welches mit fluidem Beschichtungsmaterial (35) gefüllt wird, wobei ein Spalt (7) zwischen der Rinne (5)und der Fläche (91) des Substrats (9) verbleibt und die Flüssigkeitsoberfläche (36) des fluiden Beschichtungsmaterials (35) an der Fläche (91) des Substrats (9) einen Meniskus (37) ausbildet, und bei welchem das Substrat (9) und die Rinne (5) entlang einer Richtung (42) mit senkrechter Komponente aneinander vorbeigeführt werden.

2. Verfahren gemäß Anspruch 1, **dadurch gekennzeichnet, daß** das Vorbeiführen so erfolgt, daß sich die Fläche (91) des Substrats (9) relativ gegenüber dem fluiden Beschichtungsmaterial (35) entlang einer Richtung vom Flüssigkeitsvolumen zu dessen Oberfläche (36) hin bewegt.

3. Verfahren gemäß einem der vorstehenden Ansprüche,
**dadurch gekennzeichnet, daß** das aneinander Vorbeiführen berührungslos erfolgt.

4. Verfahren gemäß einem der vorstehenden Ansprüche,
**dadurch gekennzeichnet, daß** Substrat (9) und Rinne (5) mit einem Spaltabstand aneinander vorbei geführt werden, der so klein ist, daß die Oberflächenspannung oder die Kapillarkräfte des fluiden Beschichtungsmaterials (35) im Spalt (7) ein Auslaufen des Beschichtungsmaterials (35) zwischen der Rinne (9) und der Fläche (91) des Substrats (9) verhindert.

5. Verfahren gemäß einem der vorstehenden Ansprüche,
**dadurch gekennzeichnet, daß** Substrat (9) und Rinne (5) mit einem Spaltabstand aneinander vorbei geführt werden, der im Bereich von 5 µm bis 500 µm, bevorzugt im Bereich von 20 µm bis 100 µm liegt.

6. Verfahren gemäß einem der vorstehenden Ansprüche,
**dadurch gekennzeichnet, daß** das Substrat (9) an der Rinne (5) vorbeibewegt wird.

7. Verfahren gemäß einem der Ansprüche 1 bis 5, **dadurch gekennzeichnet, daß** die Rinne (5) am Substrat (9) vorbeibewegt wird.

8. Verfahren gemäß einem der vorstehenden Ansprüche,
**dadurch gekennzeichnet, daß** das Vorbeiführen in im wesentlichen vertikaler Richtung erfolgt.

9. Verfahren gemäß einem der Ansprüche 1 bis 7, **dadurch gekennzeichnet, daß** das Vorbeiführen in schräger Richtung erfolgt.

10. Verfahren gemäß einem der vorstehenden Ansprüche,
**dadurch gekennzeichnet, daß** das Substrat (9) mit einem fluiden Beschichtungsmaterial versehen wird, welches zumindest einen Bestandteil eines elektrolumineszenten Materials aufweist.

11. Verfahren gemäß einem der vorstehenden Ansprüche,
**dadurch gekennzeichnet, daß** das Substrat (9) mit einem fluiden Beschichtungsmaterial versehen wird, welches zumindest einen Bestandteil eines Materials einer funktionellen OLED-Schicht, insbesondere einer Lochinjektions-, Potentialanpassungs-, Elektronenblockier-, Lochblockier-, Elektronenleiter-, oder Elektroneninjektionsschicht aufweist.

12. Verfahren gemäß einem der vorstehenden Ansprüche,
**dadurch gekennzeichnet, daß** das Substrat (9) mit einem Photolack beschichtet wird.

13. Verfahren gemäß einem der vorstehenden Ansprüche,
**dadurch gekennzeichnet, daß** das Substrat (9) mit einer Funktionalschicht, insbesondere einer Antireflex-, Antikratz-, Antihaft-, oder Antischmutzschicht versehen wird.

14. Verfahren gemäß einem der vorstehenden Ansprüche,
**dadurch gekennzeichnet, daß** das Substrat (9) mit einem Vakuumhalter gehaltert wird.

15. Verfahren gemäß einem der vorstehenden Ansprüche,
**dadurch gekennzeichnet, daß** das Substrat (9) elektrostatisch gehaltert wird.

16. Verfahren gemäß einem der vorstehenden Ansprüche,
**dadurch gekennzeichnet, daß** das Substrat durch Adhäsion an einer Adhäsionsfläche gehaltert wird.

17. Verfahren gemäß einem der vorstehenden Ansprüche,
**dadurch gekennzeichnet, daß** das Substrat (9) durch Klammerung gehaltert wird.

18. Verfahren gemäß einem der vorstehenden Ansprüche,
**dadurch gekennzeichnet, daß** der horizontale Abstand zwischen Substrat (9) und Rinne (5) geregelt wird.

19. Verfahren gemäß Anspruch 18, **dadurch gekennzeichnet, daß** die horizontale Position der Rinne (5) geregelt wird.

20. Verfahren gemäß Anspruch 18 oder 19, **dadurch gekennzeichnet, daß** die horizontale Position des Substrats geregelt wird.

21. Verfahren gemäß einem der Ansprüche 18 bis 20, **dadurch gekennzeichnet, daß** der horizontale Abstand in Abhängigkeit von einer Abstandsmessung geregelt wird.

22. Verfahren gemäß einem der vorstehenden Ansprüche,
**dadurch gekennzeichnet, daß** die horizontale Parallelität oder der Winkel zwischen Substrat (9) und Rinne (5) geregelt wird.

23. Verfahren gemäß einem der vorstehenden Ansprüche,
**dadurch gekennzeichnet, daß** ein Gasströmungskissen erzeugt wird, welches auf eine Fläche (91, 92) des Substrats wirkt.

24. Verfahren gemäß einem der vorstehenden Ansprüche,
**dadurch gekennzeichnet, daß** die Fläche (91) des Substrats (9) an wenigstens einem zum Substrat (9) hin geöffneten Gasreservoir (91) vorbeigeführt wird.

25. Verfahren gemäß einem der vorstehenden Ansprüche
**dadurch gekennzeichnet, daß** zumindest einer der Parameter
- Schichtdicke der aufgetragenen Beschichtung (40),
- Temperatur des Substrats (9),
- Temperatur der Rinne (5),
- Gaszusammensetzung der Atmosphäre über der Rinne (5),
- Temperatur des Beschichtungsmaterials (35), und
- Ziehgeschwindigkeit gemessen wird.

26. Verfahren gemäß einem der vorstehenden Ansprüche
**dadurch gekennzeichnet, daß** das Beschichten mit einer Ziehgeschwindigkeit in einem Bereich von 0,1 bis 10 mm pro Sekunde erfolgt.

27. Verfahren gemäß einem der vorstehenden Ansprüche,
**dadurch gekennzeichnet, daß** fluides Beschichtungsmaterial mit einer Viskosität zwischen 0.1 und 400 mPa·s, bevorzugt zwischen 0.5 und 100 mPa·s, besonders bevorzugt zwischen 5 und 100 mPa·s verwendet wird.

28. Vorrichtung (1) zur Flüssigbeschichtung eines Substrats (9), insbesondere geeignet zur Durchführung eines Verfahrens gemäß einem der vorstehenden Ansprüche, welche
- zumindest eine seitlich geöffnete Rinne (5) zur Aufnahme von fluidem Beschichtungsmaterial (35),
- eine Halterung für ein der seitlichen Öffnung der Rinne (5) zugewandtes Substrat (9),
- eine Einrichtung zum aneinander Vorbeiführen eines gehalterten Substrats (9) und der Rinne (5) entlang einer Richtung (42) mit senkrechter Komponente unter Beibehaltung eines Spalts (7) zwischen Rinne (5)und der der Rinne (5) zugewandten Fläche (91) des Substrats (9) umfaßt.

29. Vorrichtung gemäß Anspruch 28, **dadurch gekennzeichnet, daß** die Einrichtung zum aneinander Vorbeiführen von Substrat (9) und Rinne (5) eine Einrichtung zur Bewegung des Substrats (9) entlang einer Richtung mit senkrechter Komponente umfaßt.

30. Vorrichtung gemäß Anspruch 28 oder 29, **dadurch gekennzeichnet, daß** die Einrichtung zum aneinander Vorbeiführen von Substrat (9) und Rinne (5) eine Einrichtung zur Bewegung der Rinne (5) entlang einer Richtung (42) mit senkrechter Komponente umfaßt.

31. Vorrichtung gemäß einem der Ansprüche 28 bis 30, **gekennzeichnet durch** eine Einrichtung (43) zur Zuführung von fluidem Beschichtungsmaterial zur Rinne (5) .

32. Vorrichtung gemäß einem der Ansprüche 28 bis 31, **dadurch gekennzeichnet, daß** die Rinne (5) Bestandteil eines Beschichtungskopfes (3) ist oder in einen Beschichtungskopf (3) eingearbeitet ist.

33. Vorrichtung gemäß Anspruch 32, **dadurch gekennzeichnet, daß** die seitliche Öffnung (47) der Rinne eine Öffnung in einer Dichtfläche (49) des Beschichtungskopfes (3) bildet.

34. Vorrichtung gemäß einem der Ansprüche 28 bis 33, **gekennzeichnet durch** eine Einrichtung zur Regelung des horizontalen Abstands zwischen Rinne (5) und der der Rinne (5) zugewandten Fläche (91) eines gehalterten Substrats (9).

35. Vorrichtung gemäß einem der Ansprüche 28 bis 34, **gekennzeichnet durch** eine Einrichtung zur Regelung des Winkels oder der horizontalen Parallelität zwischen Rinne (5) und der der Rinne (5) zugewandten Fläche (91) eines gehalterten Substrats (9).

36. Vorrichtung gemäß einem der Ansprüche 28 bis 35, **gekennzeichnet durch** eine Einrichtung zur Erfassung des horizontalen Abstands zwischen Rinne (5) und der der Rinne (5) zugewandten Fläche (91) eines gehalterten Substrats (9).

37. Vorrichtung gemäß Anspruch 36, **dadurch gekennzeichnet, daß** die Einrichtung zur Erfassung des horizontalen Abstands zumindest einen Sensor vom Typ eines Tastsensors, optischen Sensors, Ultraschallsensors oder Staudrucksensors umfasst.

38. Vorrichtung gemäß einem der Ansprüche 28 bis 37, **dadurch gekennzeichnet, daß** die Halterung einen Vakuumhalter umfasst.

39. Vorrichtung gemäß einem der Ansprüche 28 bis 38, **dadurch gekennzeichnet, daß** die Halterung einen elektrostatischen Halter umfasst.

40. Vorrichtung gemäß einem der Ansprüche 28 bis 39, **dadurch gekennzeichnet, daß** die Halterung eine Adhäsionsfläche umfasst.

41. Vorrichtung gemäß einem der Ansprüche 28 bis 40, **dadurch gekennzeichnet, daß** die Halterung eine Klemmeinrichtung umfaßt.

42. Vorrichtung gemäß einem der Ansprüche 28 bis 41, **gekennzeichnet durch** zumindest ein zu einem gehalterten Substrat hin geöffnetes Gasreservoir (61).

43. Vorrichtung gemäß Anspruch 42, **gekennzeichnet durch** zumindest eine Gasversorgungseinrichtung für das Gasreservoir (61).

44. Vorrichtung gemäß einem der Ansprüche 28 bis 43, **gekennzeichnet durch** eine Einrichtung zur Messung zumindest einer der Parameter
- Schichtdicke der aufgetragenen Beschichtung (40),
- Temperatur des Substrats (9),
- Temperatur der Rinne (5),
- Gaszusammensetzung der Atmosphäre über der Rinne (5),
- Temperatur des Beschichtungsmaterials (35), und
- Ziehgeschwindigkeit.

45. Vorrichtung gemäß einem der Ansprüche 28 bis 44, **gekennzeichnet durch** eine Einrichtung zur Schwingungsdämpfung.

46. Vorrichtung gemäß einem der Ansprüche 28 bis 45, **gekennzeichnet durch** eine Dichtungseinrichtung zur Abdichtung des Spalts (7).

47. Verwendung eines Verfahrens oder einer Vorrichtung gemäß einem der vorstehenden Ansprüche zur Herstellung einer organischen lichtemittierenden Diode, insbesondere zum Aufbringen einer organischen funktionellen Schicht, insbesondere fürorganische Optoelektronik-Vorrichtungen, beispielsweise für Leuchtflächen, Beleuchtungsflächen, Signage-Produkte, für Hinterleuchtungen für LCD- oder ähnliche Displays, oder organische Photovoltaik-Vorrichtungen.

48. Verwendung eines Verfahrens oder einer Vorrichtung gemäß einem der vorstehenden Ansprüche zur Herstellung von Photolack-Beschichtungen, optischen Filterschichten und Interferenzbeschichtungen oder Kratzschutzbeschichtungen.
